# EUROPEAN PATENT APPLICATION

(11) **EP 4 715 874 A1**
(43) Date of publication of application: **25.03.2026**
(21) Application number: 24218329.1
(22) Date of filing: 09.12.2024
(51) Int. Cl.: H01L 23/373, H01L 23/367, H01L 23/473

(54) **HEAT DISSIPATION DEVICE AND POWER MODULE ADAPTED THERETO**

(30) Priority: 24.09.2024 CN 202411332507
(71) Applicant: Delta Electronics, Inc., Taoyuan City 333 (TW)
(72) Inventor: Chiang, Chun-Liang, 333 Taoyuan City (TW); Chiu, Hung-Nien, 333 Taoyuan City (TW); Yang, Chih-Wei, 333 Taoyuan City (TW); Ou Yang, Jhen, 333 Taoyuan City (TW); Wu, Chun-Han, 333 Taoyuan City (TW)
(74) Representative: Uexküll & Stolberg

(57) **Abstract**

A heat dissipation device (100, 100a, 100b) adapted to a power module includes a first plate body (20, 20a, 20b) and a second plate body (30, 30a, 30b). The first plate body (20, 20a, 20b) includes a first plate element (21) having a first surface (211) and a second surface (212) opposite to each other, wherein the first surface (211) faces toward a heat source in the power module, and the first plate element (21) includes plural holes (22, 22a, 22a', 22b, 22b') penetrating the first surface (211) and the second surface (212). The second plate body (30, 30a, 30b) is stacked with the first plate body (20, 20a, 20b) and includes a second plate element (31) and plural protruding elements (32, 32a, 32a', 32b, 32b'). The second plate element (31) includes a third surface (311) and a fourth surface (312) opposite each other, wherein the third surface (311) is adjacent to the second surface (212), and the plural protruding elements (32, 32a, 32a', 32b, 32b') are disposed on the third surface (311). At least a portion of the plural protruding elements (32, 32a, 32a', 32b, 32b') penetrate in the plural holes (22, 22a, 22a', 22b, 22b') and contact with the heat source.

## Description

### FIELD OF THE INVENTION

The present disclosure relates to a heat dissipation device, and more particularly to a heat dissipation device adapted to a power module.

### BACKGROUND OF THE INVENTION

Generally, a power module may include a heat dissipation device for dissipating heats generated from the heat source therein, so as to improve the reliability and durability thereof.

In general, the heat dissipation device includes two stacked plates, wherein the lower plate has a plurality of protrusions disposed thereon toward the upper plate, so that the plurality of protrusions are located between two plates. The lower plate is used to contact the heat source, such as circuit board, in the power module, and the heats from the heat generating components on the circuit board are brought away through contacting with the liquid cooling system. In this way, the heats generated from the heat source are transmitted to the lower plate first and then to the plurality of protrusions, and are finally brought away by the cooling liquid passing through the protrusions. That is, before being brought away by the cooling system, the heats are transmitted by multiple medias, which accordingly leads to poor heat dissipation efficiency. Also, the combination between two plates has to be achieved through such as soldering, for example, the upper plate has to be soldered to the protrusions on the lower plate, which increases the complexity for assembling the heat dissipation device.

Therefore, there is a need of providing a heat dissipation device and a power module adapted thereto for improving the drawbacks described above.

### SUMMARY OF THE INVENTION

An object of the present disclosure is to provide a heat dissipation device and a power module adapted thereto, wherein the heat dissipation device is advantageous of improved heat dissipation efficiency and simplified assembling procedure.

In accordance with an aspect of the present disclosure, a heat dissipation device adapted to a power module is provided. The heat dissipation device includes a first plate body and a second plate body. The first plate body includes a first plate element having a first surface and a second surface opposite to each other, wherein the first surface faces toward a heat source in the power module, and the first plate element includes a plurality of holes penetrating the first surface and the second surface. The second plate body is stacked with the first plate body and includes a second plate element and a plurality of protruding elements. The second plate element includes a third surface and a fourth surface opposite each other, wherein the third surface is adjacent to the second surface, and the plurality of protruding elements are disposed on the third surface. At least a portion of the plurality of protruding elements penetrate in the plurality of holes and contact with the heat source.

In accordance with another aspect of the present disclosure, a power module is provided. The power module includes a heat source and a heat dissipation device for dissipating heats from the heat source. The heat dissipation device a first plate body and a second plate body. The first plate body includes a first plate element having a first surface and a second surface opposite to each other, wherein the first surface faces toward the heat source, and the first plate element includes a plurality of holes penetrating the first surface and the second surface. The second plate body is stacked with the first plate body and includes a second plate element and a plurality of protruding elements. The second plate element includes a third surface and a fourth surface opposite each other, wherein the third surface is adjacent to the second surface, and the plurality of protruding elements are disposed on the third surface. At least a portion of the plurality of protruding elements penetrate in the plurality of holes and contact with the heat source.

In the present disclosure, through the structural design of disposing the protruding elements on the upper second plate body to penetrate the lower first plate body, the heat dissipation device makes a portion of the second plate body, which contacts with the liquid-cooling system, directly contact with the heat source in the power module, thereby effectively improving the heat transmission efficiency and thus increasing the heat dissipation effect. Moreover, the sectional size and sectional shape of the protruding elements can be varied to correspond to those of the contacted heat sources, thereby further ensuring the heat dissipation effect. Furthermore, through penetrating the protruding elements in the lower first plate body, the assembling process between two plate bodies can be simultaneously completed with the combination process between the heat dissipation device and the heat source in the power module, which significantly simplifies the assembling process.

### BRIEF DESCRIPTION OF THE DRAWINGS

The above contents of the present disclosure will become more readily apparent to those ordinarily skilled in the art after reviewing the following detailed description and accompanying drawings, in which:
FIG. 1 is a schematic view showing a heat dissipation device in an assembled state according to an embodiment of the present disclosure;
FIG. 2A is an exploded schematic view showing the heat dissipation device according to the embodiment of the present disclosure;
FIG. 2B is an exploded schematic view showing the heat dissipation device according to the embodiment of the present disclosure from another view angle;
FIG. 3A is a side view of a first plate body of the heat dissipation device according to the embodiment of the present disclosure;
FIG. 3B is a side view of the heat dissipation device in an assembled state according to the embodiment of the present disclosure;
FIG. 4 is a three-dimensional cross-sectional view of the heat dissipation device in an assembled state according to an embodiment of the present disclosure;
FIG. 5 is a top view of a heat dissipation device in a separate state according to another embodiment of the present disclosure; and
FIG. 6 is a top view of a heat dissipation device in a separate state according to further another embodiment of the present disclosure.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

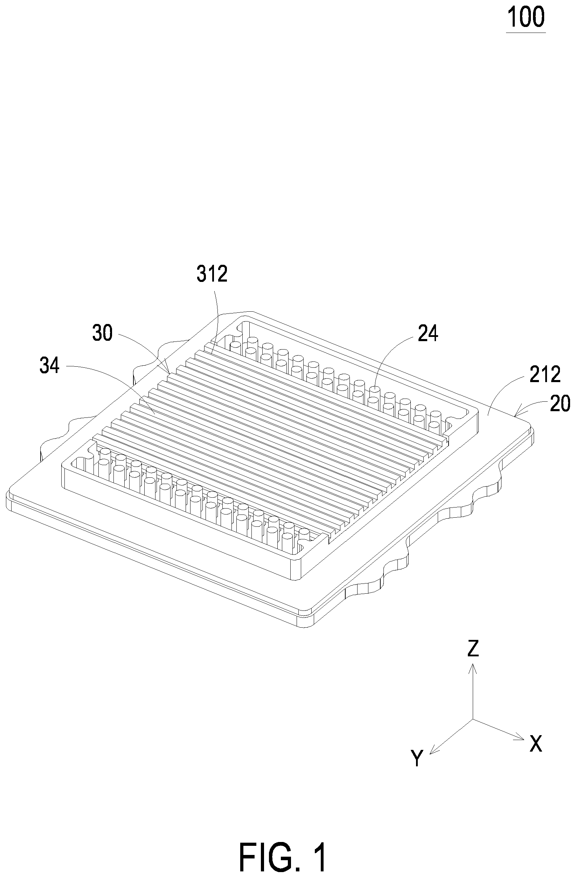

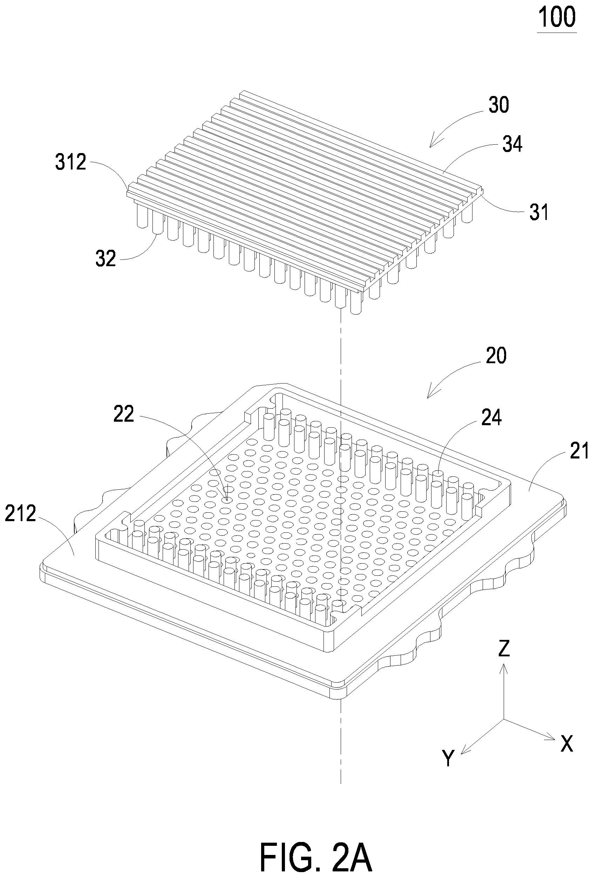

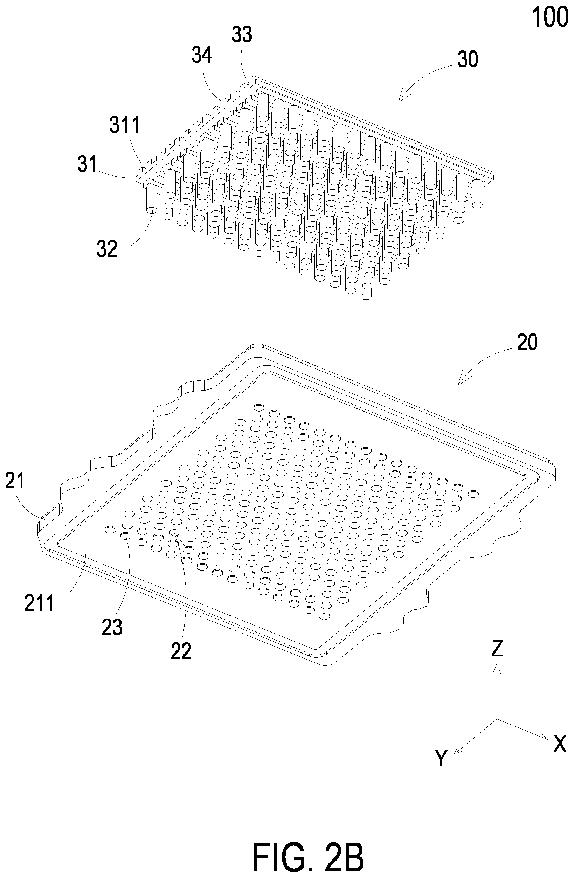

Please refer to FIG. 1, FIG. 2A and FIG. 2B. FIG. 1 is a schematic view showing a heat dissipation device in an assembled state according to an embodiment of the present disclosure, FIG. 2A is an exploded schematic view showing the heat dissipation device according to the embodiment of the present disclosure, and FIG. 2B is an exploded schematic view showing the heat dissipation device according to the embodiment of the present disclosure from another view angle. A heat dissipation device 100 according to the present disclosure includes a first plate body 20 and a second plate body 30 which are arranged in a manner that the second plate body 30 is disposed at the top of the first plate body 20, namely, the second plate body 30 is higher than the first plate body 20 in a Z axis direction. The first plate body 20 includes a first plate element 21, and the second plate body 30 includes a second plate element 31. The first plate element 21 of the first plate body 20 has a first surface 211 and a second surface 212 opposite to each other, and the first surface 211 is lower than the second surface 212 in the Z axis direction. The second plate element 31 of the second plate body 30 has a third surface 311 and a fourth surface 312 opposite to each other, and the third surface 311 is lower than the fourth surface 312 in the Z axis direction. When the first plate body 20 and the second plate body 30 are stacked together, the second surface 212 of the first plate body 20 and the third surface 311 of the second plate body 30 are adjacent to each other.

The heat dissipation device 100 of the present disclosure is used in a power module for dissipating heats from a heat source (not shown). For example, the heat source might be a circuit board, such as a circuit board adopting the AMB ceramic substrate, or other types of circuit board. Especially, it is able to dissipate heats from a heat generating component, such as die, on the circuit board. In practice, the heat dissipation device 100 is disposed on the circuit board in a direction that the first surface 211 faces the circuit board and is combined therewith through a soldering or sintering process, and then the heat dissipation device 100 further contacts with a liquid-cooling system for heat dissipation. For example, the liquid in the liquid-cooling system passes through the second plate body 30 and a space between the first plate body 20 and the second plate body 30, so as to bring away heats generated from components on the circuit board that is contacted therewith, thereby achieving the heat dissipation effect.

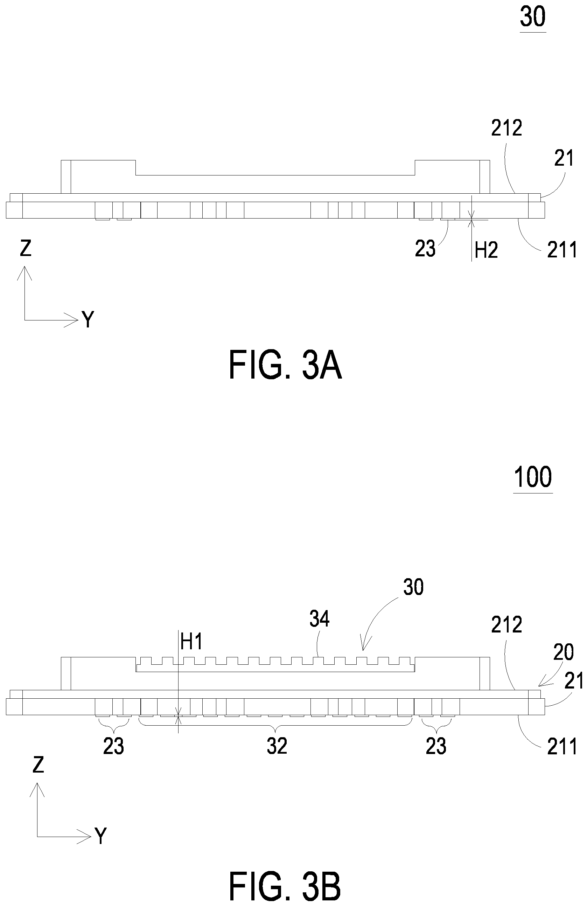

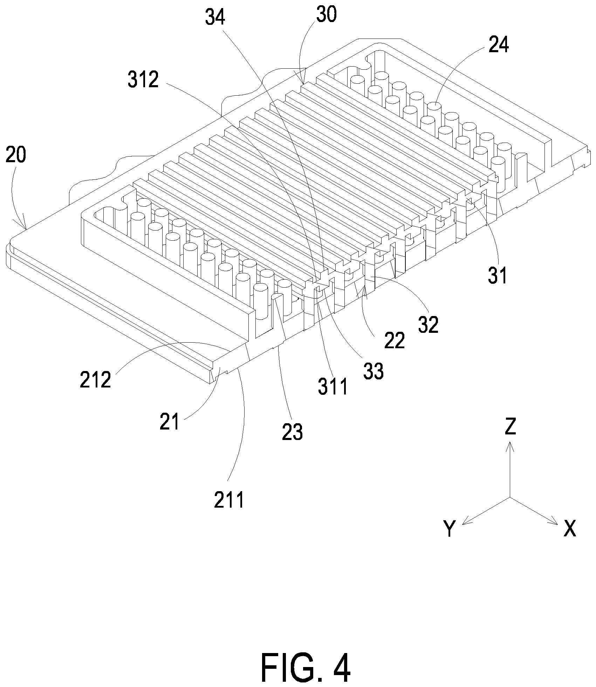

In order to simultaneously enhance the heat dissipation effect and improve the assembling process, the heat dissipation device 100 according to the present disclosure employs a special structure design. Please refer to FIG. 1 to FIG. 4. FIG. 3A is a side view of a first plate body of the heat dissipation device according to the embodiment of the present disclosure, FIG. 3B is a side view of the heat dissipation device in an assembled state according to the embodiment of the present disclosure, and FIG. 4 is a three-dimensional cross-sectional view of the heat dissipation device in an assembled state according to an embodiment of the present disclosure. The first plate element 21 includes a plurality of holes 22 penetrating the first surface 211 and the second surface 212, and the second plate body 30 further includes a plurality of protruding elements 32 disposed on the third surface 311 of the second plate element 31 and facing the second surface 212 of the first plate body 20. Particularly, positions of the holes 22 are corresponding to positions of the protruding elements 32. That is, when the first plate body 20 and the second plate body 30 are stacked together, the protruding elements 32 on the second plate element 31 will penetrate in the corresponding holes 32 and be exposed at the first surface 211 of the first plate element 21. Under this configuration, the protruding elements 32 which are part of the second plate body 20 are directly contacted with the heat source, such as the circuit board, so that the heats can be directly transmitted to the second plate body 20 which directly contacts with the liquid-cooling system without an intermediate transmission by the first plate body 20, which effectively increases the heat dissipation efficiency.

Based on differences in the circuit boards and the components disposed thereon in different power modules, the number and positions of the protruding elements 32 penetrating the holes 22 can be varied in accordance with practical situations, for example, the number and positions of the protruding elements 32 can be varied for matching with the number and positions of the heat generating components on the circuit board. In an embodiment, all of the protruding elements 32 of the second plate body 32 are implemented to penetrate the first plate element 21 via the holes 22. In another embodiment, a portion of the protruding elements 32 of the second plate body 30 are implemented to penetrate the first plate element 21 via the holes 22, and other portion thereof are placed against the second surface 212 of the first plate element 21 and not penetrate the first plate element 21. In other words, the number of holes 22 is varied in accordance with the number of protruding elements 32, which penetrate the first plate element 21, and the numbers of the two are identical.

The exposure of the protruding elements 32 at the first surface 211 of the first plate element 21 also can be varied in accordance with practical situations. For example, in an embodiment, the protruding elements 32 are implemented to be flush with the first surface 211. In another embodiment, as shown in FIG. 3B, the protruding elements 32 are implemented to have a first protruding height H1 relative to the first surface 211. For example, the first protruding height H1 can be decided in accordance with the height of the components on the circuit board facing the first surface 211, such as to range between 0.1 nm and 0.2 nm; and under this situation, the first plate body 20 can correspondingly include a plurality of bulges 23 disposed on the first surface 211 and having a second protruding height H2 relative to the first surface 211, so that the bulges 23 and the protruding elements 32 can collectively configure the contact surface facing the circuit board. In other words, the first protruding height H1 can be greater than or equal to zero, and the second protruding height H2 is greater than zero. Notably, the first protruding heights H2 of individual protruding elements 32 can be identical or different, the second protruding heights H2 of individual bulges 23 can be identical or different, and the first protruding height H1 and the second protruding height H2 also can be identical or different. For example, in accordance with different heights of different components relative to the disposition surface of the circuit board, the protruding elements 32/bulges 23 with greater protruding heights can be located at positions corresponding to the components with less heights, and/or the protruding elements 32/bulges 23 with less protruding heights can be located at positions corresponding to the components with greater heights. Therefore, variations are not limited by the drawings.

On the other hand, in the present disclosure, the design that the protruding elements 32 penetrate the holes 22 is also beneficial to simplify the assembling process between the first plate body 20 and the second plate body 30. Since the protruding elements 32 are directly disposed on the second plate element 31 and directly inserted in the holes 22 of the first plate element 21, through the soldering or sintering process for disposing the heat dissipation device 100 to the circuit board, the combination between the second plate body 30 and the first plate body 20 can be completed at the same time. Therefore, the step of soldering the upper plate to the protrusions on the lower plate in the prior art can be eliminated. More specifically, the existing process for combining the heat dissipation device 100 and the circuit board is utilized in the present disclosure to complete the assembling of two plate bodies. Further, since the solder (such as sheet solder) melted during the soldering or sintering process will fill the gaps between the holes 22 and the protruding elements 32, it can also ensure that the liquid of the liquid-cooling system does not leak from the gaps. Therefore, the widths of the gaps between the holes 22 and the protruding elements 32 are not limited, and no matter the two are tightly or loosely fitted, the gaps still can be filled by melted solder. In addition, the melted solder is also helpful in filling the difference among protruding heights of the protruding elements 32/bulges 23 on the first surface 211.

The first plate body 20 can be integrally formed or formed by combining separate parts, and similarly, the second also can be integrally formed or formed by combining separate parts, without limitation. In a preferable embodiment, the first plate body 20 is implemented as one piece and the second plate body 30 is implemented as one piece, and through penetrating the protruding elements 32 in the holes 22 and the soldering process between the first surface 211 and the circuit board, the assembling between two plate bodies and the combination between the heat dissipation device 100 and the circuit board can be simultaneously achieved by lest steps.

Moreover, the first plate body 20 further includes a plurality of protruding portions 24 disposed on the second surface 212 of the first plate element 21, and the protruding portions 24 and the protruding elements 32 collectively form the heat dissipation structures between the first plate element 21 and the second plate element 31, which helps increase the flow rate of the liquid in the liquid-cooling system therebetween. Furthermore, the second plate body 30 further includes a first bumpy structure 33 disposed on the third surface 311 and a second bumpy structure 34 disposed on the fourth surface 312, wherein the bumpy structures can increase the contact areas of the second plate body 30 with the liquid in the liquid-cooling system, thereby improving the heat dissipation effect. In an embodiment, the protruding elements 32 can be disposed on the relatively raised portions of the second bumpy structure 34; in another embodiment, the protruding elements 32 can be disposed on the relatively lowered portions of the second bumpy structure 34; in further another embodiment, the protruding elements 32 can be disposed on the relatively raised and lowered portions of the second bumpy structure 34. Therefore, it can be varied without being limited by the drawings.

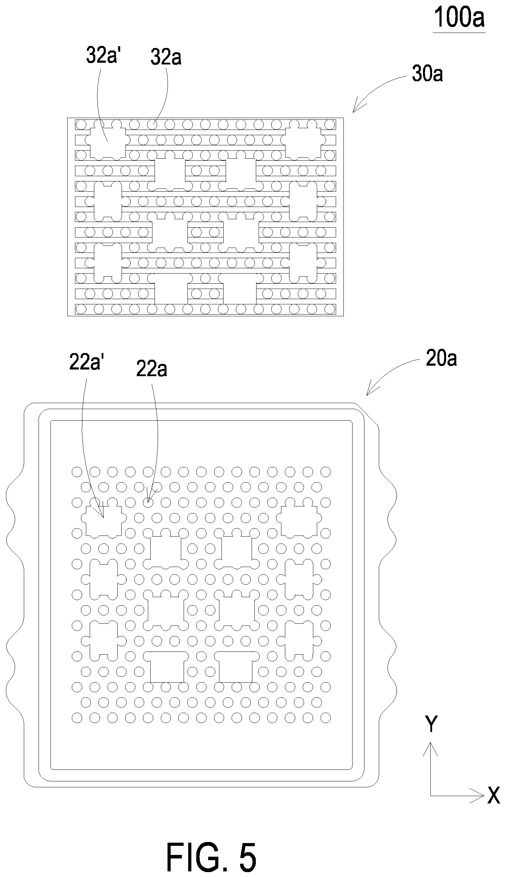

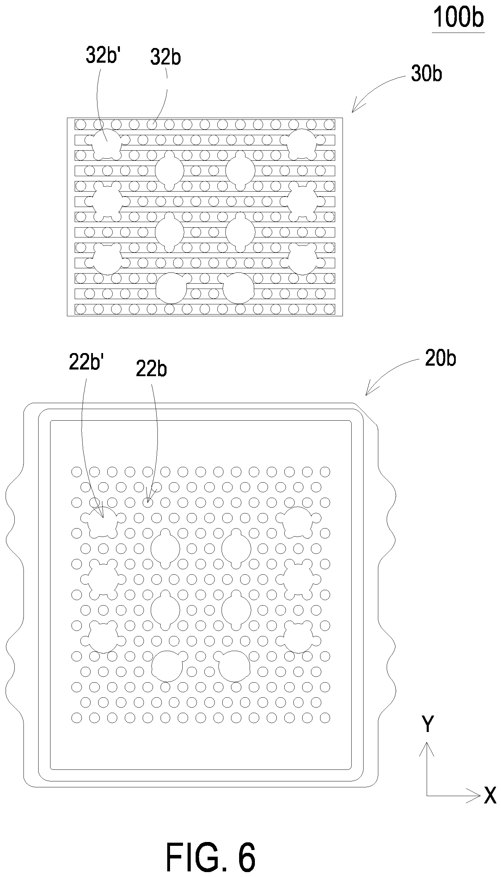

Please refer to FIG. 5 and FIG. 6. FIG. 5 is a top view of a heat dissipation device in a separate state according to another embodiment of the present disclosure, and FIG. 6 is a top view of a heat dissipation device in a separate state according to further another embodiment of the present disclosure. The sectional shapes/sizes of the protruding elements in a direction along the third surface of the second plate element can be varied in accordance with dimensions of components that generate higher level of heats on the circuit board. For example, when the component that generates higher level of heats, such as die, has a greater sectional size along the disposition surface thereof, the sectional size of the protruding element, which is located at a position corresponding thereto, can be increased, so as to match with the greater size of said component.

In an embodiment, as shown in FIG. 5, a heat dissipation device 100a includes a first plate body 20a and a second plate body 30a. The first plate body 20a includes a plurality of holes 22a and a plurality of holes 22a', and the second plate body 30a includes a plurality of protruding elements 32a and a plurality of protruding elements 32a', wherein the sectional shapes of the protruding elements 32a and the holes 22a are substantially the same, the sectional shapes of the protruding elements 32a' and the holes 22a' are substantially the same, the sectional size of the protruding elements 32a' is greater than that of the protruding elements 32a, and the sectional size of the holes 22a' is greater than that of the holes 22a. In this embodiment, the sectional shape of the protruding elements 32a' is a square-like shape. Under this situation, the protruding elements 32a' are suitable for disposing at positions corresponding to the components, which generate higher level of heats and have a similar square-like shape, thereby further enhancing the thermal conduction effect for said components.

In an embodiment, as shown in FIG. 6, a heat dissipation device 100b includes a first plate body 20b and a second plate body 30b. The first plate body 20b includes a plurality of holes 22b and a plurality of holes 22b', and the second plate body 30b includes a plurality of protruding elements 32b and a plurality of protruding elements 32b', wherein the sectional shapes of the protruding elements 32b and the holes 22b are substantially the same, the sectional shapes of the protruding elements 32b' and the holes 22b' are substantially the same, the sectional size of the protruding elements 32b' is greater than that of the protruding elements 32b, and the sectional size of the holes 22b' is greater than that of the holes 22b. In this embodiment, the sectional shape of the protruding elements 32b' is a round-like shape. Under this situation, the protruding elements 32b' are suitable for disposing at positions corresponding to the components, which generate higher level of heats and have a similar round-like shape, thereby further enhancing the thermal conduction effect for said components.

It should be noted that the numbers respectively of the holes 22a', 22b' and the protruding elements 32a', 32b' can be single or multiple, and the positions thereof are not limited to match with the components which generate higher level of heats and can be increased or reduced in accordance with practical requirements without being limited by the drawings.

In another embodiment, the first plate bodies 20a, 20b are implemented to merely include the holes 22a', 22b' for penetrating thereof the protruding elements 32a', 32b' with greater sectional sizes, namely, the holes 22a, 22b are not formed and other protruding elements 32a, 32b do not penetrate the first plate bodies 20a, 20b, thereby particularly improving heat transmission for the components generating higher level of heats.

In other embodiments, the shape of the protruding elements with greater sectional size can be implemented to be other shapes, such as polygons, irregular shapes, etc. Therefore, it is not limited by the drawings and can be varied in accordance with practical situations.

Accordingly, the disposition of the protruding elements can be varied in accordance with practical requirements. For example, the sectional shapes/sizes of the plurality of protruding elements can be identical or different, the distances between different pairs of adjacent protruding elements can be identical or different, and/or the number and positions of the protruding elements that penetrate the first plate body can be varied, such that after comprehensive considerations, the protruding elements can match with the components, especially the components generating higher level of heats, on the circuit board, thereby obtaining the best heat dissipation effect. Therefore, it is not limited by the drawings.

Also, it should be noted that since the flow rate of liquid between the first plate body and the second plate body is influenced by the protruding elements/protruding portions therebetween, when considering the sizes and positions of the protruding elements 32, 32a, 32a' and the protruding portions 24, a balance should be maintained between the flow rate of the liquid in the liquid-cooling system and the spacing of the protruding elements/protruding portions, so as avoid too large sectional size and/or too small spacing from hindering the flow of the liquid and causing the opposite effect of reducing heat dissipation efficiency.

In addition, in the present disclosure, the first plate body 20, 20a, 20b and the second plate body 30, 30a, 30b of the heat dissipation device 100, 100a, 100b can be made of metal material, such as copper, aluminum, iron etc., or other materials commonly used for heat dissipation, without limitation.

In conclusion, through the structural design of disposing the protruding elements on the upper second plate body to penetrate the lower first plate body, the heat dissipation device of the present disclosure makes a portion of the second plate body, which contacts with the liquid-cooling system, directly contact with the heat source in the power module, thereby effectively improving the heat transmission efficiency and thus increasing the heat dissipation effect. Moreover, since the protruding elements penetrate the lower first plate body, the assembling between the first plate body and the second plate body can be simultaneously completed with the soldering process between the first plate body and the heat source, which significantly simplifies the assembling process. Furthermore, the sectional size(s), sectional shape(s), number and/or positions of the protruding elements and/or the number and positions of the protruding elements that penetrate the first plate body all can be varied in accordance with the configuration of the heat source, which provides flexibility.

## Claims

1. A heat dissipation device (100, 100a, 100b) adapted to a power module, **characterized by** comprising:
a first plate body (20, 20a, 20b), comprising:
a first plate element (21) having a first surface (211) and a second surface (212) opposite to each other, wherein the first surface (211) faces toward a heat source in the power module, and the first plate element (21) comprises a plurality of holes (22, 22a, 22a', 22b, 22b') penetrating the first surface (211) and the second surface (212); and
a second plate body (30, 30a, 30b) stacked with the first plate body (20, 20a, 20b), the second plate body (30, 30a, 30b) comprising:
a second plate element (31) having a third surface (311) and a fourth surface (312) opposite each other, wherein the third surface (311) is adjacent to the second surface (212); and
a plurality of protruding elements (32) disposed on the third surface (311), wherein at least a portion of the plurality of protruding elements (32, 32a, 32a', 32b, 32b') penetrate in the plurality of holes (22, 22a, 22a', 22b, 22b') and contact with the heat source.

2. The heat dissipation device (100, 100a, 100b) as claimed in claim 1, wherein an assembling process between the first plate body (20, 20a, 20b) and the second plate body (30, 30a, 30b) is achieved through a combination process between the first plate body (20, 20a, 20b) and the heat source.

3. The heat dissipation device (100, 100a, 100b) as claimed in claim 2, wherein the heat source is a circuit board in the power module, and the combination process is a soldering process or a sintering process.

4. The heat dissipation device (100, 100a, 100b) as claimed in claim 1, wherein a number of the plurality of holes (22, 22a, 22a', 22b, 22b') is identical to a number of the at least a portion of the plurality of protruding elements (32, 32a, 32a', 32b, 32b').

5. The heat dissipation device (100, 100a, 100b) as claimed in claim 1, wherein each of the plurality of protruding elements (32, 32a, 32a', 32b, 32b') has a sectional shape in a direction along the third surface (311), and the plurality of protruding elements (32, 32a, 32a', 32b, 32b') comprise at least two kinds of sectional shapes.

6. The heat dissipation device (100, 100a, 100b) as claimed in claim 5, wherein one of the at least two kinds of sectional shapes is corresponding to a shape of a heat generating component of the heat source.

7. The heat dissipation device (100, 100a, 100b) as claimed in claim 1, wherein each of the plurality of protruding elements (32, 32a, 32a', 32b, 32b') has a height relative to the third surface (311), and the plurality of protruding elements (32, 32a, 32a', 32b, 32b') comprise at least two kinds of heights relative to the third surface (311).

8. The heat dissipation device (100, 100a, 100b) as claimed in claim 1, wherein the at least a portion of the plurality of protruding elements (32, 32a, 32a', 32b, 32b') are penetrated in the plurality of holes (22, 22a, 22a', 22b, 22b') and exposed at the first surface (211), and have a first protruding height (H1) relative to the first surface (211), and the first protruding height (H1) is greater than or equal to zero.

9. The heat dissipation device (100, 100a, 100b) as claimed in claim 1, wherein the third surface (311) of the second plate element (31) comprises a first bumpy structure (33), and the plurality of protruding elements (32, 32a, 32a', 32b, 32b') are disposed on the first bumpy structure (33).

10. The heat dissipation device (100, 100a, 100b) as claimed in claim 1, wherein the fourth surface (312) of the second plate element (31) comprises a second bumpy structure (34).

11. The heat dissipation device (100, 100a, 100b) as claimed in claim 1, wherein the first plate body (20, 20a, 20b) further comprises a plurality of bulges (23) disposed on the first surface (211), the plurality of bulges (23) have a second protruding height (H2) relative to the first surface (211), and the second protruding height (H2) is greater than zero.

12. The heat dissipation device (100, 100a, 100b) as claimed in claim 1, wherein the first plate body (20, 20a, 20b) further comprises a plurality of protruding portions (24) disposed on the second surface (212) and facing toward the third surface (311).

13. The heat dissipation device (100, 100a, 100b) as claimed in claim 1, wherein the heat dissipation device (100, 100a, 100b) is contacted with a liquid-cooling system for heat dissipation.

14. A power module, **characterized by** comprising:
a heat source; and
a heat dissipation device (100, 100a, 100b) for dissipating heats from the heat source, comprising:
a first plate body (20, 20a, 20b), comprising:
a first plate element (21) having a first surface (211) and a second surface (212) opposite to each other, wherein the first surface (211) faces toward the heat source, and the first plate element (21) comprises a plurality of holes (22, 22a, 22a', 22b, 22b') penetrating the first surface (211) and the second surface (212); and
a second plate body (30, 30a, 30b) stacked with the first plate body (20, 20a, 20b), the second plate body (30, 30a, 30b) comprising:
a second plate element (31) having a third surface (311) and a fourth surface (312) opposite each other, wherein the third surface (311) is adjacent to the second surface (212); and
a plurality of protruding elements (32, 32a, 32a', 32b, 32b') disposed on the third surface (311), wherein at least a portion of the plurality of protruding elements (32, 32a, 32a', 32b, 32b') penetrate in the plurality of holes (22, 22a, 22a', 22b, 22b') and contact with the heat source.
